(19) Europäisches Patentamt

European Patent Office

Office européen des brevets

(11) **EP 4 682 556 A1**

(12) **EUROPEAN PATENT APPLICATION**

(43) Date of publication:
**21.01.2026 Bulletin 2026/04**

(21) Application number: **24382759.9**

(22) Date of filing: **15.07.2024**

(51) International Patent Classification (IPC):
*G01R 31/3163* [(2006.01)]   *G01R 31/28* [(2006.01)]

(52) Cooperative Patent Classification (CPC):
**G01R 31/2874**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicants:
  • **Universitat Politècnica De Catalunya**
    **08034 Barcelona (ES)**
  • **Consejo Superior de Investigaciones Cientificas**
    **28006 Madrid (ES)**
  • **Universidad de Sevilla**
    **41013 Sevilla (ES)**

(72) Inventors:
  • **VÁZQUEZ GARCÍA DE LA VEGA, Diego**
    **41013 Sevilla (ES)**
  • **ESPEJO MEANA, Servando Carlos**
    **41013 Sevilla (ES)**
  • **DOMINGUEZ PUMAR, Manuel María**
    **08028 Barcelona (ES)**
  • **MANYOSA VILARDELL, Xavier**
    **08034 Barcelona (ES)**
  • **CEBALLOS CÁCERES, Joaquín Francisco**
    **28006 Madrid (ES)**

(74) Representative: **Torner, Juncosa I Associats, SL C / Pau Claris, 108, 1r 1a 08009 Barcelona (ES)**

(54) **METHOD FOR MEASURING THE THERMAL IMPEDANCE IN THE FREQUENCY DOMAIN**

(57) The present invention relates to a method for measuring the thermal impedance in the frequency domain, the method comprising defining the thermal impedance in the frequency domain as the ratio between a temperature of a device under test (100) and a power supplied to the device under test at a frequency; measuring a response signal v0(t) to an input signal i(t) that is supplied at a frequency $\omega$; calculating said temperature a) as v0(t)·sin($\omega$·t)/i(t) and b) as v0(t)·cos($\omega$·t)/i(t)(20) and calculating said power c) as v0(t)·sin($\omega$·t)·i(t) and d) as v0(t)·cos($\omega$·t)·i(t), wherein the input signal i(t) is a square signal, of period T and 50% duty cycle, which ranges between two values IH and IL; calculating the thermal impedance in the frequency domain by means of processing the calculated temperature and power.

FIG. 3

EP 4 682 556 A1

## Description

### Field of the Invention

The present invention relates to methods for measuring thermal impedance. Particularly, the present invention relates to a method for measuring the thermal impedance in the frequency domain.

### Background of the Invention

Measurement of the thermal impedance in the frequency domain is a technique used to characterize the thermal properties of materials and systems, especially in semiconductor engineering and thermal management of electronic devices.

In general, thermal impedance is defined as

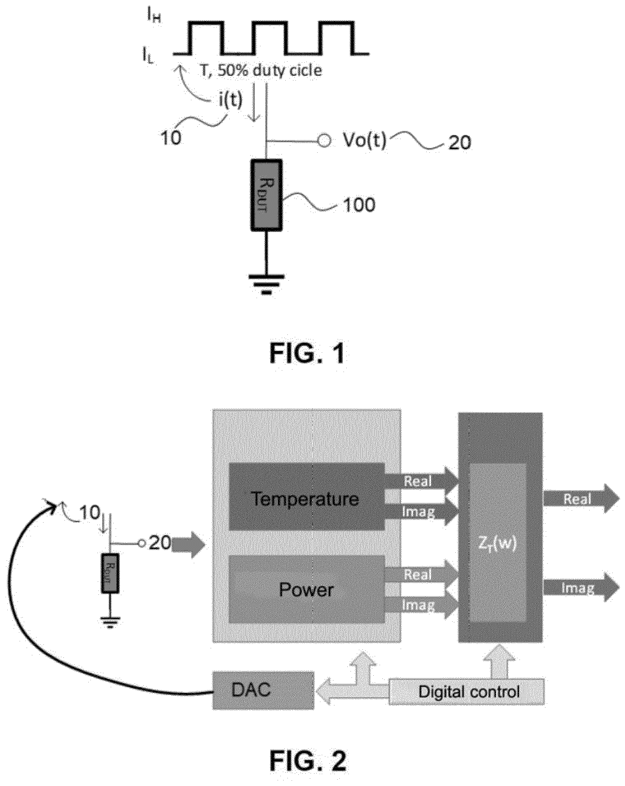

$$Z_T(j\omega) = \frac{T(jw)}{P(jw)}$$ , where T(jw) is the temperature of a device under test and P(jw) the power supplied to a device when the input has a frequency $\omega$ (period $2\pi/\omega$). Fig. 1 shows an example of the circuit used.

Furthermore, the relationship between the current signal applied i(t) and circuit response ($V_o$) is given by $V_o = R_{DUT} * i(t)$, where $R_{DUT}$ generally represents a resistor that changes with temperature, such as a platinum resistor, the behavior of which can be described as follows:

$$R_{DUT} = R_0\{1 + \alpha[T(t) - T_0]\},$$

where $R_o$ is the resistor taken at temperature $T_0$ and "$\alpha$" is a thermal coefficient.

Based on the foregoing, it can be deduced that:

$$T(t) = \frac{1}{\alpha}\left[\frac{1}{R_o}\frac{V_o(t)}{i(t)} - 1\right] + T_0$$ .

Therefore, temperature T depends on the division $\frac{V_o(t)}{i(t)}$ .

On the other hand, the power supplied can be defined as $P(t) = [V_o(t)i(t)]$, whereas power P depends on the product $V_o(t)i(t)$.

In summary, obtaining the thermal impedance $Z_T(jw)$ involves calculating the product and division of $V_o(t)$ and i(t) at a given frequency.

Patent EP 3594669-B1 discloses a method for determining the thermal impedance of a device under test. According to this method, a device under test is heated to an initial temperature and a pulsed power including a sequence of pulses is applied thereto. Temperature of the device is measured in a time-dependent manner. Finally, the thermal impedance of the device under test is determined based on its temperature and the pulsed power.

Furthermore, the method referred to as 3w can also be used to measure thermal impedance. This method is based on the application of an alternating current (AC) at an angular frequency w through a sample. The alternating current generates a temperature variation having components at the original frequency ($1\omega$), the duplicate frequency ($2\omega$), as well as a triplicate frequency (3w). The technique is referred to as "3-omega" because it focuses on the 3w frequency component of the temperature response. The third harmonic is the one used in the inference as it depends in the first order only on the magnitudes to be measured (thermal impedance, properties of the materials or speed of the fluid in the case of anemometers). The scientific article by Aleksandrova, Mariya et al.: "Implementation of $3\omega$ Method for Studying the Thermal Conductivity of Perovskite Thin Films", Journal Crystals, Vol. 12, 20 September 2022 provides an application example thereof.

The 3w method allows measuring the thermal properties of materials with very low thermal conductivities and is applicable to a wide variety of materials. It is also used in absolute anemometry (R. Heyd, et al., "Development of absolute hot-wire anemometry by the $3\omega$ method", Review of Scientific Instruments 81, 044901 (2010)). The main advantage is that, in this case, measurement depends on air temperature in the second order only. However, it requires a very high precision, which involves a complex and delicate circuitry.

Therefore, new methods particularly for measuring the thermal impedance in the frequency domain, allowing the integration thereof in ASIC, are needed.

### Summary of the Invention

To that end, embodiments of the present invention provide a method for measuring the thermal impedance in the frequency domain. The method comprises defining the thermal impedance in the frequency domain $Z_T$ (j$\omega$) as the ratio between a temperature of a device under test (for example, a resistor that changes with temperature, such as a platinum resistor, among others) and a power supplied to the device under test for a frequency w; calculating the temperature by means of multiplying a response signal $v_o(t)$ by the inverse of a constant and by a sine of the same frequency as an input signal i(t), and performing subsequent digitization and integration of an obtained result; and multiplying the response signal $v_o(t)$ by the inverse of the constant and by a cosine of the same frequency as the input signal i(t), and performing subsequent digitization and integration of an obtained result; calculating the power by means of multiplying the response signal $v_o(t)$ by the constant and by a sine of the same frequency as the input signal i(t), and performing subsequent digitization and integration of an obtained result; and multiplying the response signal $v_o(t)$ by the constant and by a cosine of the same frequency as the input signal i(t), and performing subsequent digitization and integration of an obtained result; and calculating the thermal impedance in the frequency domain by means of processing the calculated temperature and power.

According to the proposed method, the input signal i(t) is a square signal, of period T and 50% duty cycle, which ranges between two values $I_H$ and $I_L$, and the mentioned constant comprises the input signal i(t) or an escalated version thereof.

In some embodiments, calculation of the temperature and power comprises calculating both their real part and their imaginary part. Particularly, said calculation comprises calculating a magnitude M of the temperature and power and the phase $\phi$ of their first harmonic.

In some embodiments, the multiplications of steps a) - d) are performed in a single step using an array of switched devices. Alternatively, the multiplications can be performed in two different steps, a first step in which an array of switched devices is used to calculate the multiplication of the response signal $v_o(t)$ by the inverse of the constant or by the constant, and a second step in which a modulator, for example, a modified sigma-delta modulator, is used to calculate a result of the previously calculated multiplication by the sine or cosine. The switched devices may comprise capacitors, resistors and/or transconductances.

In some embodiments, the modified sigma-delta modulator comprises a first time-variable device $X_1$ with weights associated with the sine or cosine, respectively.

In some embodiments, the input signal i(t) is generated using a DAC, for example, of one or more bits.

Brief Description of the Drawings

The foregoing and other features and advantages will be more completely understood based on the following detailed description of several embodiments that is merely illustrative and nonlimiting in reference to the attached drawings, in which:

Fig. 1 schematically illustrates the circuit used for measuring the thermal impedance in the frequency domain, according to an embodiment of the present invention.

Fig. 2 schematically illustrates the proposed diagram/architecture for measuring the thermal impedance in the frequency domain, according to an embodiment of the present invention.

Fig. 3 schematically illustrates the conceptual blocks implemented by the proposed method, according to an embodiment of the present invention.

Fig. 4 schematically illustrates the input channel which includes the product block and the digital conversion.

Fig. 5 schematically illustrates a first-order sigma-delta modulator with the switched devices technique, according to an embodiment of the present invention.

Fig. 6A shows an embodiment of the implementation of a variable capacitor with weights associated with a sine. The signals $\Phi_X$ are digital controls. Fig. 6B shows the levels that would correspond to the values of the capacitors to implement the sine. Note that the sign of the input signal must be inverted to generate negative lobes.

Detailed Description of the Invention and Embodiments

Thermal impedance in the frequency domain $Z_T$ (j$\omega$), as explained above, is defined as the ratio between the temperature of a device under test (100) and the power supplied to the device under test for a frequency w. Particularly, the present invention proposes the use, as an input signal i(t) (10), of a square signal of period T and 50% duty cycle ranging between two values $I_H$ and $I_L$. This input signal contains different harmonics, in addition to a direct or DC component, and can be expressed according to the development thereof in Fourier series as follows: $i(t) = i_{DC} + \sum_{k\,odd} A_{ik} \sin(k\omega t)$, of which only the first harmonic (k=1) is of interest and the rest of the harmonics must be filtered by the measurement system itself.

Fig. 2 shows the architecture proposed for measuring/calculating the thermal impedance in the frequency domain $Z_T$ (j$\omega$). In this case, it would be made up of respective conversion channels to extract the real and imaginary parts of temperature and power, a digital processing block to extract thermal impedance, a digital control block to control A/D conversion paths and in turn to control the generation of the input signal i(t) (10) from a 1-bit DAC, for example, among others.

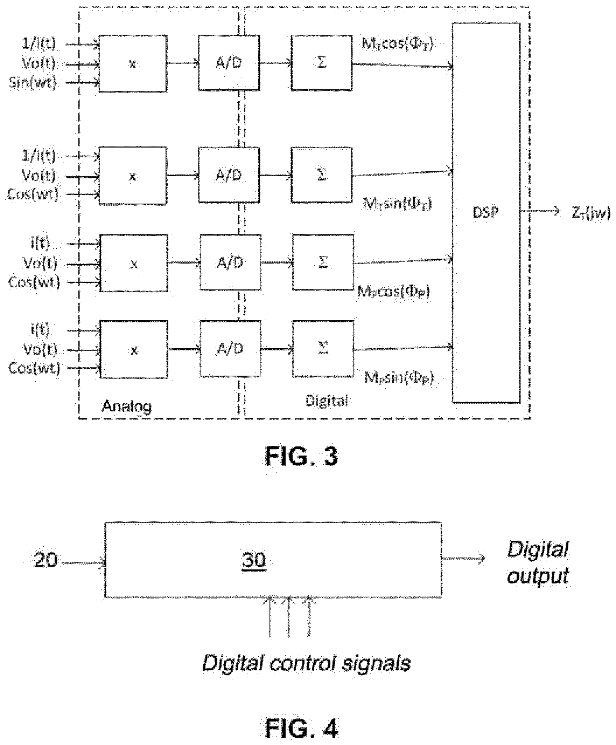

According to the embodiment of Fig. 3, two channels are used to calculate temperature and two other channels are used to calculate power. To calculate temperature in one of the channels, the product of the response signal $v_o(t)$ (20) is calculated by multiplying by the inverse of a constant (which can be the input signal i(t) (10) or an escalated version thereof) and by a sine of the same frequency as the input signal i(t) (10), followed by the digitalization and integration of the obtained result by means of the analog-digital converter. For the other channel, the product of the response signal $v_o(t)$ (20) is calculated by multiplying by the inverse of the constant and by a cosine of the same frequency as the input signal i(t) (10), followed by the digitalization and integration of the obtained result. To calculate power in one of the channels, the product of the response signal $v_o(t)$ (20) is calculated by multiplying by the constant and by a sine of the same frequency as the input signal i(t) (10), followed by digitalization and integration of the obtained result. For the other channel, the product of the response signal $v_o(t)$ (20) is calculated by multiplying by the constant and by a cosine of the same frequency as the input signal i(t) (10), followed by the digitalization and integration of the obtained result.

Finally, calculation of the thermal impedance in the frequency domain is performed, for example, by means of digital or arithmetic processing, in the digital domain, of the previously calculated temperature and power.

According to the proposed method, the different products described above can be obtained by means of a single step or two different steps. If they are obtained by means of a single step, an array of switched devices, for example, capacitors, resistors, conductances, etc., can be used. If they are obtained by means of two different steps, the first step can use an array of switched devices to calculate the multiplication of the response signal $v_o(t)$ (20) by the inverse of the constant or by the constant, and the second step can use a modified sigma-delta modulator (30), see Figs. 3 and 4, for calculating the result of the previously calculated multiplication by the sine or cosine.

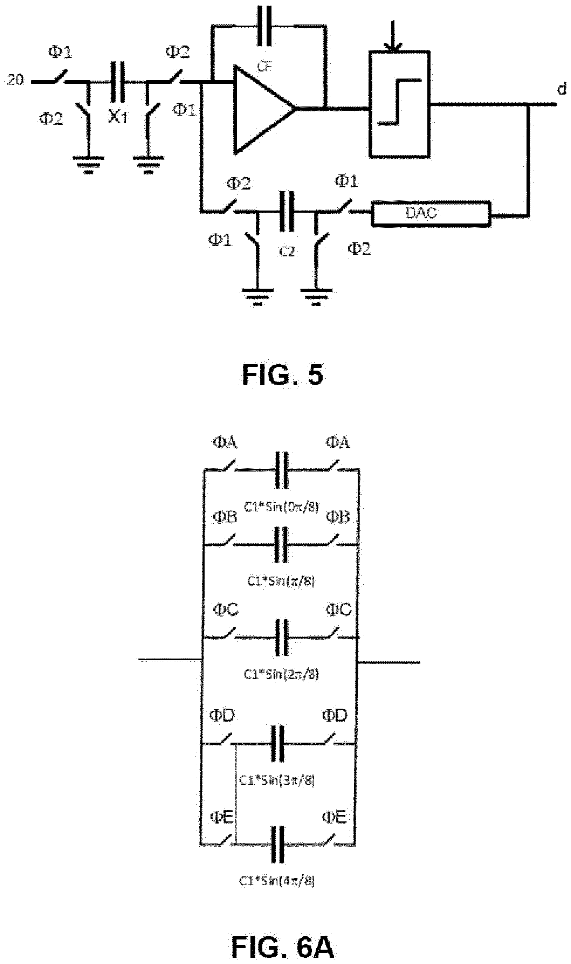

Fig. 5 shows an embodiment of the sigma-delta modulator (30) using, in this case, the switched capacitor or SC technique. To that end, the modulator includes an amplifier, an edge-triggered comparator, a time-variable capacitor (X1) with weights associated with the sine or cosine, capacitors C2 and CF, and switches controlled by two non-overlapping clock phases ($\Phi$1 and $\Phi$2). The input is the response signal $v_o(t)$ (20) and the digital output is d. For this specific implementation, the scale factor "k" is defined as the X1/C2 ratio.

Note that in other embodiments that are not illustrated, depending on the technique implemented by the sigma-delta modulator (30), the time-variable device (X1) will be of one type or another. For example, if the implemented technique is RC, the variable device will be a resistor, if the technique is Gm-C, the variable device will be a transconductance, and if the technique is MOSFET-C, the variable device will be a transistor.

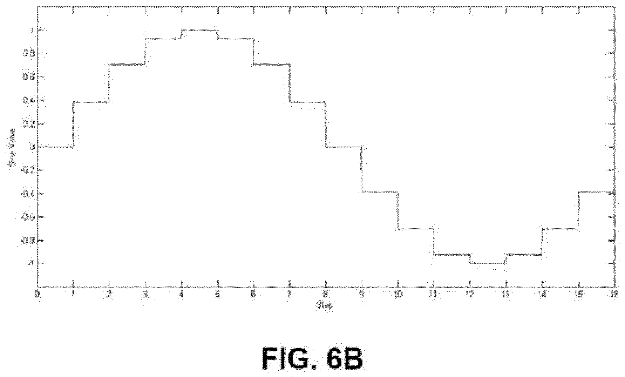

Figs. 6A and 6B show an embodiment of the implementation of the sine or cosine in a discrete manner using a variable capacitor as a time-variable device. In this case, 16 period levels are used so that the error introduced is not significant, since the larger the number of levels, the smaller the error that is introduced. Due to the inherent properties of the circuit, to implement (in the absence of a sign) all the steps of the period, only four capacitors are required, therefore one of them is null.

In this way, the weight of the modulator input is in turn modulated with a capacitor the value of which gradually changes according to a sine or cosine pattern. Given that negative capacitors cannot be made, the same effect is achieved with positive capacitors and the input signal is inverted (i.e., multiplied by -1) when said negative values should act. If positive and negative signal values are available, it is immediate because exchanging the input lines by means of a pair of switches is sufficient. Otherwise, a (readily implementable) inversion step must be introduced. In any case, inversion of the input signal with appropriate control of the switches can be implemented in a simple manner with the switched capacitors technique.

The scope of the present invention is defined in the attached claims.

## Claims

1.  A method for measuring the thermal impedance in the frequency domain, the method comprising:

    - defining the thermal impedance in the frequency domain $Z_T$ (j$\omega$) as the ratio between a temperature of a device under test (100) and a power supplied to the device under test for a frequency w;
    - calculating said temperature by means of:

        a) multiplying a response signal $v_o(t)$ (20) by the inverse of a constant and by a sine of the same frequency as an input signal i(t) (10), and performing subsequent digitization and integration of an obtained result; and
        b) multiplying the response signal $v_o(t)$ (20) by the inverse of the constant and by a cosine of the same frequency as the input signal i(t) (10), and performing subsequent digitization and integration of an obtained result;

    - calculating said power by means of:

        c) multiplying the response signal $v_o(t)$ (20) by the constant and by a sine of the same frequency as the input signal i(t) (10), and performing subsequent digitization and integration of an obtained result; and
        d) multiplying the response signal $v_o(t)$ (20) by the constant and by a cosine of the same frequency as the input signal i(t) (10), and performing subsequent digitization and integration of an obtained result;

    wherein the input signal i(t) (10) is a square signal, of period T and 50% duty cycle, which ranges between two values $I_H$ and $I_L$, and said constant comprises the input signal i(t) (10) or an escalated version thereof; and

        - calculating the thermal impedance in the frequency domain by means of processing the calculated temperature and power.

2.  The method according to claim 1, wherein the calculation of the temperature and power comprises calculating both their magnitude M and the $\phi$ phase of their first harmonic.

3. The method according to claim 1 o 2, wherein the multiplications of steps a) - d) are performed in a single step using an array of switched devices.

4. The method according to claim 1 or 2, wherein the multiplications of steps a) - d) are performed in two different steps, a first step in which an array of switched devices is used to calculate the multiplication of the response signal $v_o(t)$ (20) by the inverse of the constant or by the constant, and a second step in which a modified sigma-delta modulator (30) is used to calculate a result of the previously calculated multiplication by the sine or cosine.

5. The method according to claim 3 or 4, wherein the switched devices comprise capacitors, resistors and/or transconductances.

6. The method according to claim 4, wherein the modified sigma-delta modulator (30) comprises a first time-variable device $X_1$ with weights associated with the sine or cosine, respectively.

7. The method according to any one of the preceding claims, wherein the input signal i(t) is generated using a DAC of one or more bits.

8. The method according to any one of the preceding claims, wherein the device under test (100) comprises a resistor that changes with temperature.

**FIG. 1**

**FIG. 2**

FIG. 3

FIG. 4

7

FIG. 5

FIG. 6A

FIG. 6B

Europäisches
Patentamt

European
Patent Office

Office européen
des brevets

# EUROPEAN SEARCH REPORT

**Application Number**

EP 24 38 2759

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | SMIRNOV VITALIY IVANOVICH ET AL: "Apparatus for Measurement of Thermal Impedance of High-Power Light-Emitting Diodes and LED Assemblies", IEEE TRANSACTIONS ON ELECTRON DEVICES, vol. 63, no. 6, 6 May 2016 (2016-05-06), pages 2431-2435, XP011610723, ISSN: 0018-9383, DOI: 10.1109/TED.2016.2556583 * paragraph [III.] * ----- | 1-8 | INV. G01R31/3163 G01R31/28 |
| A | US 3 672 204 A (GREEN DONALD R) 27 June 1972 (1972-06-27) * column 2, lines 11-67; figure 1 * ----- | 1-8 | |
| A | CN 110 456 264 B (CHINA ELECTRONIC PRODUCT RELIABILITY AND ENVIRONMENTAL TESTING RES INS) 30 July 2021 (2021-07-30) * claims 2-4; figure 2 * ----- | 1-8 | |
| | | | TECHNICAL FIELDS SEARCHED (IPC) |
| | | | G01R G01N G01K |

The present search report has been drawn up for all claims

| Place of search | Date of completion of the search | Examiner |
|---|---|---|
| The Hague | 26 November 2024 | Wilhelm-Shalganov, J |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons
........................................................................
& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 24 38 2759

This annex lists the patent family members relating to the patent documents cited in the above-mentioned European search report.
The members are as contained in the European Patent Office EDP file on
The European Patent Office is in no way liable for these particulars which are merely given for the purpose of information.

26-11-2024

| Patent document cited in search report | | Publication date | Patent family member(s) | Publication date |
|---|---|---|---|---|
| US 3672204 | A | 27-06-1972 | NONE | |
| CN 110456264 | B | 30-07-2021 | NONE | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 3594669 B1

**Non-patent literature cited in the description**

- **ALEKSANDROVA, MARIYA et al.** Implementation of 3ω Method for Studying the Thermal Conductivity of Perovskite Thin Films. *Journal Crystals*, 20 September 2022, vol. 12

- **R. HEYD et al.** Development of absolute hot-wire anemometry by the 3ω method. *Review of Scientific Instruments*, 2010, vol. 81, 044901